(19) Europäisches Patentamt
European Patent Office
Office européen des brevets

(11)  **EP 3 455 164 B1**

(12)  **FASCICULE DE BREVET EUROPEEN**

(45) Date de publication et mention de la délivrance du brevet:
**08.07.2020  Bulletin 2020/28**

(51) Int Cl.:
**C22C 19/07** (2006.01)    **H01L 35/16** (2006.01)
**C01B 19/00** (2006.01)    **C01G 51/00** (2006.01)

(21) Numéro de dépôt: **17727299.4**

(22) Date de dépôt: **11.05.2017**

(86) Numéro de dépôt international:
**PCT/FR2017/051142**

(87) Numéro de publication internationale:
**WO 2017/194889 (16.11.2017 Gazette 2017/46)**

(54) **MATÉRIAU THERMOÉLECTRIQUE À BASE D'UN ALLIAGE DE SULFURE DE COBALT ET D'ANTIMOINE AVEC DU SÉLÉNIUM, DOPÉ PAR DU TELLURE, ET PROCÉDÉS D'OBTENTION**

THERMOELEKTRISCHES MATERIAL AUS EINER TELLUR-DOTIERTEN KOBALTANTIMONSULFIDLEGIERUNG MIT SELEN UND VERFAHREN ZUR HERSTELLUNG DAVON

THERMOELECTRIC MATERIAL MADE FROM A TELLURIUM DOPED COBALT ANTIMONY SULFIDE ALLOY WITH SELENIUM, AND METHODS FOR OBTAINING SAME

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **11.05.2016  FR 1654203**

(43) Date de publication de la demande:
**20.03.2019  Bulletin 2019/12**

(73) Titulaire: **IMRA Europe SAS**
**06560 Valbonne (FR)**

(72) Inventeurs:
• **CHMIELOWSKI, Radoslaw**
  **06250 Mougins (FR)**
• **PERE, Daniel**
  **06800 Cagnes Sur Mer (FR)**
• **JACOB, Stéphane**
  **06160 Juan Les Pins (FR)**
• **DENNLER, Gilles**
  **06550 La Roquette Sur Siagne (FR)**
• **BHATTACHARYA, Sandip**
  **44233 Düsseldorf (DE)**
• **MADSEN, Georg**
  **1220 Wien (AT)**

• **MORIYA, Kenzo**
  **Nagakute**
  **Aichi 408-1152 (JP)**

(74) Mandataire: **Berger, Helmut**
  **Cabinet Weinstein**
  **176 avenue Charles de Gaulle**
  **92200 Neuilly sur Seine (FR)**

(56) Documents cités:
• **CHMIELOWSKI R ET AL: "High thermoelectric performance of tellurium doped paracostibite", JOURNAL OF MATERIALS CHEMISTRY C: MATERIALS FOR OPTICAL AND ELECTRONIC DEVICES, vol. 4, no. 15, 10 février 2016 (2016-02-10), pages 3094-3100, XP055270948, The Royal Society of Chemistry [GB] ISSN: 2050-7526, DOI: 10.1039/C6TC00410E cité dans la demande**
• **YE X ET AL: "Effect of Te-Se-S Triple Doping on the Thermoelectric Properties of CoSb3 Skutterudites", JOURNAL OF ELECTRONIC MATERIALS, vol. 44, no. 6, 3 décembre 2014 (2014-12-03), pages 1674-1678, XP035494256, The Mineral, Metals & Materials Society, Warrendale, PA [US] ISSN: 0361-5235, DOI: 10.1007/S11664-014-3512-8 [extrait le 2014-12-03]**

**EP 3 455 164 B1**

**Description**

L'invention concerne principalement un matériau thermoélectrique à base d'un alliage de sulfure de cobalt et d'antimoine avec du sélénium, le dit alliage est dopé par du tellure sur le site de 'antimoine.

L'effet thermoélectrique est un phénomène physique présent dans certains matériaux qui lie le flux de chaleur qui les traverse à la puissance électrique qui les parcourt.

Les matériaux thermoélectriques ont ainsi la double capacité de générer une puissance électrique lorsqu'ils sont exposés à un gradient de température (effet Seebeck), et de générer un flux de chaleur lorsqu'un courant électrique leur est appliqué dans la masse (effet Peltier).

Les performances des matériaux thermoélectriques dépendent de la gamme de température dans lesquelles ils sont utilisés.

La publication YE X ET AL: "Effect of Te-Se-S Triple Doping on the Thermoelectric Properties of CoSb3 Skutterudites", JOURNAL OF ELECTRONIC MATERIALS, vol. 44, no. 6, 3 décembre 2014, XP035494256, divulgue un composé thermoélectrique de formule $CoSb_{2.79}Te_{0.16}Se_{0.05-x}S_x$ (x = 0, 0,01, 0,025, 0,04, 0,05) réalisé par un procédé de SPS (spark plasma sintering). La publication High thermoelectric performance of tellurium doped paracostibite, Chmielowski et al., Journal of Materials Chemistry C, Royal Society of Chemistry, 10 février 2016, divulgue un nouveau matériau thermoélectrique à base de sulfure de cobalt et d'antimoine dopé de type n par du tellure sur le site de l'antimoine.

Si ce matériau thermoélectrique permet d'obtenir des facteurs de puissance élevés de l'ordre de 2700 $\mu W.K^{-2}.m^{-1}$ au-delà de 300°C, sa conductivité thermique reste importante avec des valeurs nettement supérieures à 5 $W.K^{-1}.m^{-1}$ en deçà de 300°C.

Dans ce contexte, la présente invention vise un matériau thermoélectrique de conductivité inférieure à celle du sulfure de cobalt et d'antimoine dopé de type n, au moins pour des températures inférieures à 300°C.

À cet effet, le composé thermoélectrique de l'invention est à base d'un alliage de sulfure de cobalt et d'antimoine avec du sélénium de formule CoSbS1-xSex, x étant selon 0 < x < 1, lequel alliage est dopé par du tellure sur les site d'antimoine.

Un ou des autres dopants peuvent être prévus.

Le composé thermoélectrique de l'invention peut également comporter les caractéristiques optionnelles suivantes considérées isolément ou selon toutes les combinaisons techniques possibles :

- x est compris entre 0,1 et 0,6
- x est égal à 0,25
- le composé thermoélectrique est de formule CoSbS0,75Se0,25
- le composé thermoélectrique est dopé par du tellure sur le site de l'antimoine
- le pourcentage atomique de tellure par rapport à l'antimoine présent dans le sulfure de cobalt et d'antimoine en stœchiométrie est compris entre 2 et 7

  - le pourcentage atomique de tellure par rapport à l'antimoine présent dans le sulfure de cobalt et d'antimoine en stœchiométrie est compris entre 5 et 6,

- lorsque le composé est dopé au tellure, l'alliage de sulfure de cobalt et d'antimoine avec du sélénium est en sous stœchiométrie d'antimoine,
- dans ce cas, le pourcentage atomique d'antimoine retiré est égal au pourcentage atomique de tellure ajouté, les pourcentages atomiques étant considérés par rapport à l'antimoine présent dans le sulfure de cobalt et d'antimoine en stœchiométrie,
- le composé thermoélectrique de l'invention est dopé sur le site du cobalt par du nickel, du palladium ou du platine.

L'invention porte également sur un procédé de fabrication d'un composé thermoélectrique tel que précédemment défini, qui est essentiellement caractérisé en ce qu'il comprend au moins :

- une première étape de synthèse du dit composé par mélange des poudres préalablement pesées de cobalt, d'antimoine, de soufre, de sélénium, de tellure et d'éventuels autre(s) dopant(s), et chauffage dudit mélange, et
- une seconde étape consistant à réaliser un compactage par frittage des poudres. Le procédé de l'invention peut également comporter les caractéristiques optionnelles suivantes considérées isolément ou selon toutes les combinaisons techniques possibles :
- le procédé comporte une étape supplémentaire de nano-structuration des poudres entre la première et la seconde étape.
- la nano-structuration est réalisée par broyage des poudres dans un broyeur à billes.
- l'étape de frittage est réalisé par la méthode de frittage intitulée SPS (Spark Plasma Sintering).

- le mélange chauffé lors de la première étape est refroidit, puis les poudres sont broyées manuellement avec un mortier.
- les poudres refroidies et broyées sont passées à travers des tamis pour obtenir des poudres présentant des tailles de particules homogènes.

D'autres caractéristiques et avantages de l'invention ressortiront clairement de la description qui en est donnée ci-dessous, à titre indicatif et nullement limitatif, en référence aux figures annexées parmi lesquelles :

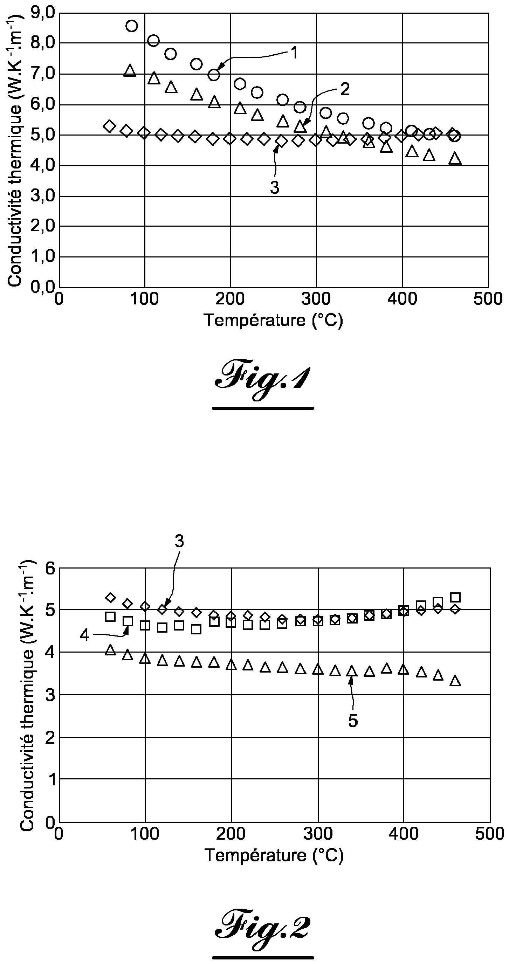

- la figure 1 est un graphique comparant l'évolution de la conductivité thermique selon la température pour un alliage du type CoSbS0,5Se0,5 préparé selon un premier mode de réalisation en comparaison avec du sulfure de cobalt et d'antimoine non dopé , et du sulfure de cobalt et d'antimoine dopé au tellure sur le site de l'antimoine ;
- la figure 2 est un graphique comparant l'évolution de la conductivité thermique selon la température pour un alliage du type CoSbS0,5Se0,5 non dopé préparé selon un premier mode de réalisation, pour un alliage de l'invention du type CoSbS0,5Se0,5 dopé au tellure sur le site de l'antimoine préparé selon un premier mode de réalisation, et pour un alliage de l'invention du type CoSbS0,5Se0,5 dopé au nickel sur le site du cobalt préparé selon un premier mode de réalisation ;

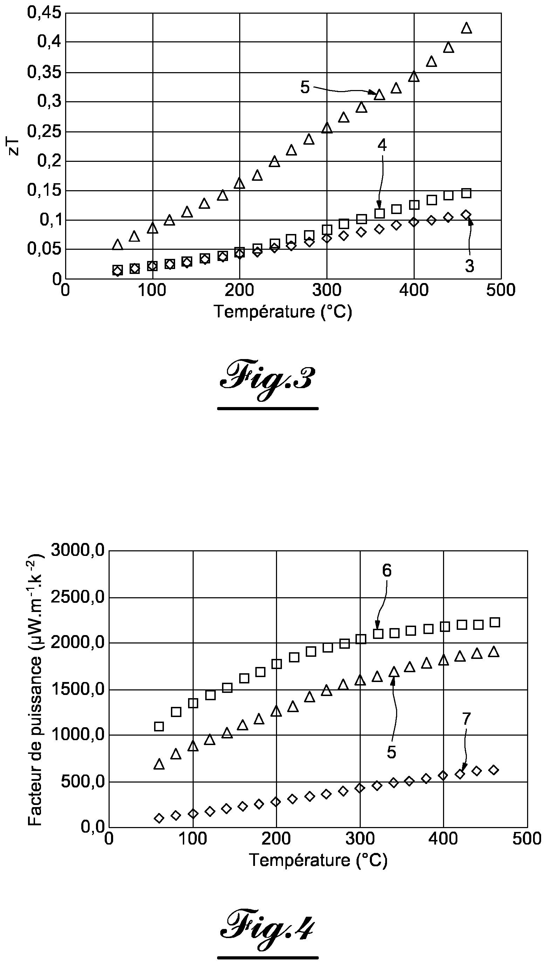

- la figure 3 est un graphique comparant l'évolution de la figure de mérite zT selon la température pour un alliage du type CoSbS0,5Se0,5 non dopé préparé selon un premier mode de réalisation, pour un alliage de l'invention du type CoSbS0,5Se0,5 dopé au tellure sur le site de l'antimoine préparé selon un premier mode de réalisation, et pour un alliage de l'invention du type CoSbS0,5Se0,5 dopé au nickel sur le site du cobalt préparé selon un premier mode de réalisation ;
- la figure 4 est un graphique comparant l'évolution du facteur de puissance selon la température pour un alliage de l'invention du type CoSbS0,75Se0,25 dopé au tellure sur le site de l'antimoine préparé selon un premier mode de réalisation, pour un alliage de l'invention du type CoSbS0,5Se0,5 dopé au tellure sur le site de l'antimoine préparé selon un premier mode de réalisation, et pour un alliage de l'invention du type CoSbS0,25Se0,75 dopé au tellure sur le site de l'antimoine préparé selon un premier mode de réalisation ;

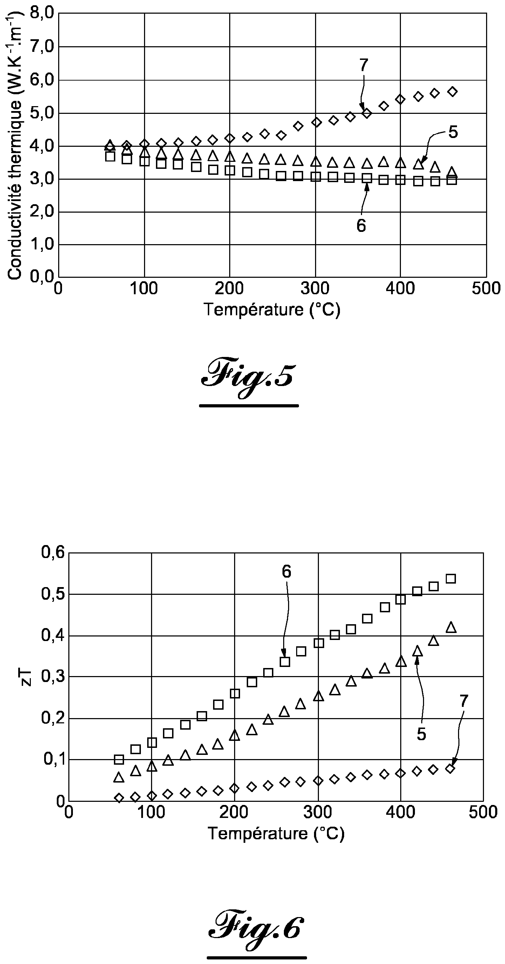

- la figure 5 est un graphique comparant l'évolution de la conductivité thermique selon la température pour un alliage de l'invention du type CoSbS0,75Se0,25 dopé au tellure sur le site de l'antimoine préparé selon un premier mode de réalisation, pour un alliage de l'invention du type CoSbS0,5Se0,5 dopé au tellure sur le site de l'antimoine préparé selon un premier mode de réalisation, et pour un alliage de l'invention du type CoSbS0,25Se0,75 dopé au tellure sur le site de l'antimoine préparé selon un premier mode de réalisation;
- la figure 6 est un graphique comparant l'évolution de la figure de mérite zT selon la température pour un alliage de l'invention du type CoSbS0,75Se0,25 dopé au tellure sur le site de l'antimoine préparé selon un premier mode de réalisation, pour un alliage de l'invention du type CoSbS0,5Se0,5 dopé au tellure sur le site de l'antimoine préparé selon un premier mode de réalisation, et pour un alliage de l'invention du type CoSbS0,25Se0,75 dopé au tellure sur le site de l'antimoine préparé selon un premier mode de réalisation;

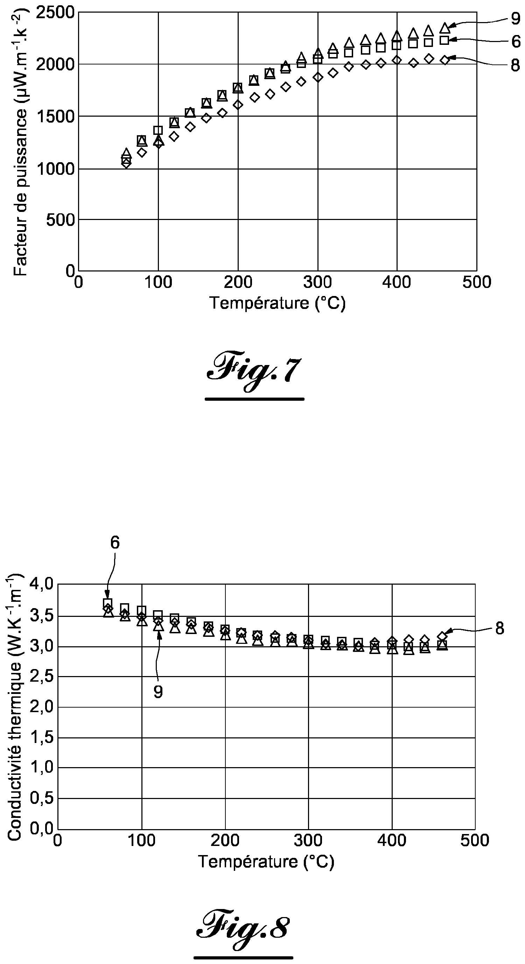

- la figure 7 est un graphique comparant l'évolution du facteur de puissance selon la température pour un alliage de l'invention du type CoSbS0,75Se0,25 dopé au tellure sur le site de l'antimoine préparé selon un premier mode de réalisation et selon des pourcentages atomiques variables de tellure par rapport à l'antimoine présent dans le sulfure de cobalt et d'antimoine en stœchiométrie;
- la figure 8 est un graphique comparant l'évolution de la conductivité thermique selon la température pour un alliage de l'invention du type CoSbS0,75Se0,25 dopé au tellure sur le site de l'antimoine préparé selon un premier mode de réalisation et selon des pourcentages atomiques variables de tellure par rapport à l'antimoine présent dans le sulfure de cobalt et d'antimoine en stœchiométrie;

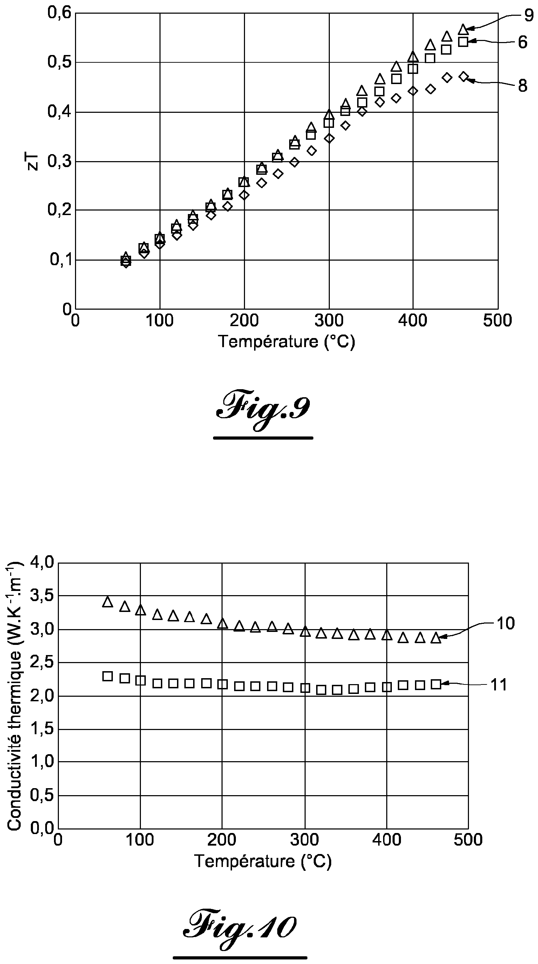

- la figure 9 est un graphique comparant l'évolution de la figure de mérite selon la température pour un alliage de l'invention du type CoSbS0,75Se0,25 dopé au tellure sur le site de l'antimoine préparé selon un premier mode de réalisation et selon des pourcentages atomiques variables de tellure par rapport à l'antimoine présent dans le sulfure de cobalt et d'antimoine en stœchiométrie ;
- la figure 10 est un graphique comparant l'évolution de la conductivité thermique d'un composé à base de CoSbS0,75S0,25 dopé à 5,5 pour cent de tellure sur le site de l'antimoine préparé selon un premier mode de réalisation et d'un même composé préparé selon un second mode de réalisation ; et

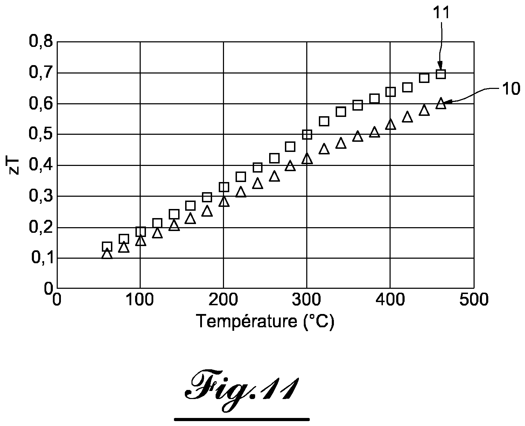

- la figure 11 est un graphique comparant l'évolution de la figure de mérite d'un composé à base de CoSbS0,75S0,25 dopé à 5,5 pour cent de tellure sur le site de l'antimoine préparé selon un premier mode de réalisation et d'un même composé préparé selon un second mode de réalisation ;

Dans la description qui suit, la référence au pourcentage atomique des différents dopants cités s'entend par le pourcentage d'atome de ce dopant par rapport au nombre d'atomes de l'élément sur lequel est positionné le dopant lorsque cet élément est présent dans le sulfure de cobalt et d'antimoine en stœchiométrie, c'est-à-dire le sulfure de cobalt et d'antimoine de formule CoSbS. On entend par ailleurs par sous « stœchiométrie correspondante » que le pourcentage atomique de l'élément sur lequel est positionné le dopant qui est retiré est égal au pourcentage atomique du dopant qui est ajouté sur le site de cet élément.

L'invention se rapporte principalement à un composé thermoélectrique à base d'un alliage de sulfure de cobalt et d'antimoine avec du sélénium de formule CoSbS1-xSex. Le composé thermoélectrique est dopé sur le site de l'antimoine par du tellure, et peut être dopé sur le site du cobalt par exemple par du nickel.

Un matériau thermoélectrique est caractérisé par sa figure de mérite zT qui s'exprime de la façon suivante :

$$ZT = \frac{S^2 \sigma T}{\kappa} \qquad (1)$$

où S est le coefficient de Seebeck ($\mu$V.K$^{-1}$)
$\sigma$ est la conductivité électrique (S.m$^{-1}$)
k est la conductivité thermique (W.K$^{-1}$.m$^{-1}$)
T la température (K)

La figure de mérite zT peut également s'exprimer de la façon suivante :

$$ZT = \frac{S^2 T}{\rho \kappa} \qquad (2)$$

où p est la résistivité électrique (en $\Omega$.m)

Le facteur de mérite zT a été conçu pour comparer les performances des matériaux thermoélectriques utilisés dans le mode Peltier. Dans le cas de l'utilisation de matériaux thermoélectriques dans le mode Seebeck, c'est-à-dire pour la génération de puissance électrique à partir d'un gradient de température, les performances des matériaux électriques peuvent être illustrées par un facteur de puissance PF qui s'exprime de la façon suivante :

$$PF = S^2 . \sigma = S^2 . \rho^{-1} \qquad (3)$$

Enfin, la conductivité thermique peut s'exprimer de la façon suivante :

$$\kappa = D.c_p.d \qquad (4)$$

Où D est la diffusivité thermique (en mm$^2$.s$^{-1}$),
$c_p$ est la capacité thermique (en J.g$^{-1}$.K$^{-1}$)
d est la densité (en g.cm$^{-3}$)

Dans les exemples ci-dessous, les performances des matériaux thermoélectriques de l'invention sont ainsi caractérisées par leur facteur de puissance PF, leur conductivité thermique et/ou leur figure de mérite zT. Les formules précédemment énoncées montrent les relations entre les différents éléments de caractérisation d'un matériau thermoélectrique. On comprend notamment que la diminution de la conductivité thermique $\kappa$ pourrait permettre d'augmenter la figure de mérite sous réserve d'un facteur de puissance suffisant.

On décrit ci-après un premier exemple de réalisation non limitatif du composé thermoélectrique de l'invention.

La préparation de l'alliage avec ou sans dopage selon ce premier mode de réalisation est réalisée en deux étapes. La première étape consiste à réaliser la synthèse du CoSbS1-xSex dans une ampoule en quartz (AQ) scellée sous vide, puis la poudre résultante est ensuite compactée par une méthode de frittage également dénommée par le terme anglophone « Spark Plasma Sintering » (SPS).

Pour synthétiser l'alliage, les poudres de cobalt, d'antimoine, de soufre, du sélénium et du ou des éventuels dopants tels que le tellure, le palladium, le nickel sont pesées en boîte à gants pour obtenir le taux de dopage souhaité.

Les quantités de poudre requises sont ensuite mélangées dans un mortier en agate pour obtenir des mélanges homogènes. Les mélanges résultants sont placés dans des ampoules en quartz qui sont scellées sous vide.

Les ampoules scellées sont alors chauffées pour atteindre la température de 923K, soit environ 650°C, et maintenues à cette température pendant 48h. Puis ces ampoules sont refroidies jusqu'au retour à la température ambiante.

Pour préparer des pastilles par SPS, les poudres refroidies sont broyées et passées à travers des tamis avec une ouverture de maille de 150 μm pour obtenir des poudres présentant des tailles de particules homogènes. Ces poudres sont alors placées dans un moule cylindrique entre deux poinçons. Le diamètre interne du moule est de 10,5 millimètres et les pistons ont un diamètre de 10 millimètres. La différence de 0,5 millimètre entre le diamètre interne du moule et le diamètre du piston permet l'addition d'une feuille de graphite entre la poudre et les poinçons d'une part et le moule d'autre part. Cette feuille de graphite supplémentaire sert à protéger le moule dans le cas où la poudre réagirait avec le moule. Ces feuilles de graphite sont aussi ajoutées sur les faces des poinçons en contact avec la poudre. Sans ces feuilles de graphite, les pastilles préparées colleraient aux poinçons après le frittage et il ne serait pas possible de les séparer.

La quantité de poudre ajoutée lors d'un compactage par SPS est choisie de telle sorte que ce compactage aboutisse à une pastille d'une hauteur d'environ 2,5 millimètres.

Le moule contenant la poudre est placé dans la chambre SPS. L'air est évacué de la chambre jusqu'à ce qu'un vide secondaire d'environ $10^{-2}$ Pascal soit atteint.

Une pression de 50 MPa est ensuite appliquée sur les deux poinçons avant de démarrer le frittage.

Le frittage est réalisé en chauffant d'abord la poudre jusque 575°C avec vitesse d'augmentation de la température de 100°C/min. Une fois la température de 575°C atteinte, cette température est maintenue pendant 15 minutes.

Pour finir, le voltage et le courant ont été arrêtés pour permettre à l'échantillon de refroidir lentement jusqu'à la température ambiante. La surface des pastilles obtenues est ensuite polie pour être nettoyée.

On mesure d'abord la diffusivité thermique par le LFA 467 de Netzsch. Ensuite la pastille est coupée en morceaux de 2.5 mm x 2.5 mm x 8 mm d'une part pour la mesure du facteur de puissance par un équipement LSR-3 de Linseis, et 2.5 mm x 2.5 mm x 1.2 mm d'autre part pour la mesure de la capacité thermique par une DSC8000 de Perkin Elmer.

La figure 1 illustre l'évolution de la conductivité thermique en fonction de la température de trois composés à savoir du CoSbS de l'art antérieur non dopé (points référencés 1), du CoSbS dopé de type n avec du tellure de l'art antérieur, le pourcentage atomique de tellure par rapport à l'antimoine présent dans le sulfure de cobalt et d'antimoine en stœchiométrie étant de 4 et l'antimoine étant en sous stœchiométrie correspondante soit à hauteur de 96 pour cent (points référencés 2), et l'alliage de formule CoSbS0,5Se0,5 qui est non dopé (points référencés 3).

On constate que la conductivité thermique de l'alliage de formule $CoSbS_{0,5}Se_{0,5}$ est significativement inférieure à celle du CoSbS non dopé jusqu'à 400°C, et également nettement inférieure à celle du CoSbS dopé de type n avec du tellure jusqu'à 300°C.

Le composé thermoélectrique à base d'un alliage de sulfure de cobalt et d'antimoine avec du sélénium permet ainsi d'obtenir des valeurs de conductivité thermique abaissées par rapport à celle du CoSbS dopé de type n avec du tellure au moins pour une gamme de température.

Les figures 2 et 3 illustrent l'évolution de la conductivité thermique et de la figure de mérite zT en fonction de la température de trois composés tous à base d'un alliage de CoSbS0,5Se0,5. Les points référencés 3 correspondent, comme la figure 1, à du CoSbS0,5Se0,5 non dopé, les points référencés 4 à du CoSbS0,5Se0,5 dopé à 4 pour cent de nickel sur le site du cobalt, le cobalt étant présent en sous stœchiométrie correspondant à hauteur de 96 pour cent, et les points référencés 5 correspondent à du CoSbS0,5Se0,5 dopé à 4 pour cent de tellure sur le site de l'antimoine, l'antimoine étant présent en sous stœchiométrie correspondante soit à hauteur de 96 pour cent.

On constate que la conductivité thermique la plus faible est obtenue pour un dopage au tellure sur le site de l'antimoine et que la figure de mérite correspondant au dopage de tellure sur le site de l'antimoine est significativement plus élevée que pour le CoSbS0,5Se0,5 non dopé et le CoSbS0,5Se0,5 dopé au nickel. Il est néanmoins à noter que les performances et la conductivité thermique du CoSbS0,5Se0,5 dopé au nickel sont du même ordre de grandeur que celles du CoSbS0,5Se0,5 non dopé ce qui fait entrer dans le champ de l'invention le CoSbS0,5Se0,5 dopé au nickel sur le site du cobalt.

Il résulte principalement des figures 2 et 3 que le dopage au tellure sur le site de l'antimoine est avantageux pour réaliser un composé thermoélectrique présentant des performances améliorées tant pour la conductivité thermique que pour la figure de mérite.

Dans les résultats présentés ci-dessous en référence aux figures 4 à 9, tous les échantillons sont réalisés à base de CoSbS1-xSex dopé au tellure sur le site de l'antimoine.

Les figures 4 à 6 illustrent l'évolution du facteur de puissance, de la conductivité thermique et de la figure de mérite zT en fonction de la température de trois composés à base de CoSbS1-xSex dopé à 4 pour cent en tellure sur le site de l'antimoine qui est en sous stœchiométrie correspondante, pour chacun desquels la valeur de x varie. Les points référencés 6 correspondent à x = 0,25, les points référencés 5 correspondent à x=0,5, et les points référencés 7 correspondent à x=0,75.

Pour un composé de formule CoSbS0,25Se0,75 dopé au tellure, la conductivité thermique est réduite jusqu'à 300°C par rapport à du CoSbS dopé de type n avec du tellure de l'art antérieur (points référencés 2 de la figure 1) tandis que son facteur de puissance supérieur à 150 $\mu$W.K$^{-2}$.m$^{-1}$ à 100°C le rend exploitable comme matériau thermoélectrique.

Pour les composés de formule respectivement CoSbS0,5Se0,5 et CoSbS0,75Se0,25 dopés au tellure, la conductivité thermique est significativement réduite par rapport à du CoSbS dopé de type n avec du tellure de l'art antérieur et ce, sur toute la gamme de température. Pour ces deux composés, le facteur de puissance atteint des valeurs élevées supérieures à 1500 $\mu$W.K$^{-2}$.m$^{-1}$ au moins au-delà de 300°C.

On constate de ces figures 4 à 6 que les meilleurs résultats sont obtenus pour un composé à base d'un alliage de formule CoSbS0,75Se0,25 tant pour le facteur de puissance, la conductivité thermique et la figure de mérite zT qui découle des valeurs abaissées de conductivité thermique.

Des tests complémentaires ont été menés pour un composé de formule CoSbS0,82Se0,18, c'est-à-dire avec x=0,18, dopé à 5,5 pour cent de tellure sur le site de l'antimoine, l'antimoine étant présent en sous stœchiométrie correspondant à hauteur de 94,5 pour cent. Pour cet alliage on obtient une conductivité thermique de 3,70 W.K$^{-1}$.m$^{-1}$ à 100°C, de 3,25 W.K$^{-1}$.m$^{-1}$ à 300°C et de 3,23 W.K$^{-1}$.m$^{-1}$ à 400°C. On obtient en outre une figure de mérite zT de 0,49 à 400°C. Ces résultats sont tout à fait proches de ceux obtenus pour x=0,25 dopé à 4 pour cent de tellure sur le site de l'antimoine.

Les figures 7 à 9 illustrent l'évolution du facteur de puissance, de la conductivité thermique et de la figure de mérite zT en fonction de la température de trois composés à base d'un alliage de formule CoSbS0,75S0,25 dopé en tellure sur le site de l'antimoine et dont le pourcentage en tellure varie. Les points référencés 6 correspondent à un dopage de 4 pour cent de tellure sur le site de l'antimoine qui est en sous stœchiométrie correspondante, les points référencés 8 correspondent à un dopage de 2,5 pour cent de tellure sur le site de l'antimoine qui est en sous stœchiométrie correspondante, et les points référencés 9 correspondent à un dopage de 5,5 pour cent de tellure sur le site de l'antimoine qui est en sous stœchiométrie.

On constate que les meilleurs résultats sont obtenus pour un dopage de 5,5 pour cent de tellure sur le site de l'antimoine. La valeur la plus haute obtenue pour le zT de l'échantillon dopé à 5,5 pour cent de tellure est de 0,57.

Au regard de l'intégralité de ces résultats, il en résulte que le composé thermoélectrique présentant les meilleures performances est l'alliage de CoSbS0,75S0,25 dopé à 5,5 en tellure sur le site de l'antimoine qui est en sous stœchiométrie.

Le liste des dopants n'est cependant pas exhaustive puisque dans le cadre de l'invention, on peut également prévoir comme dopant sur le site du cobalt du palladium ou du platine. On peut également prévoir un dopage à la fois sur le site de l'antimoine et du cobalt.

On décrit ci-après un second exemple de réalisation non limitatif du composé thermoélectrique de l'invention.

Dans ce second mode de réalisation, une étape de nano-structuration est ajoutée entre l'étape de synthèse du CoSbS1-xSex dans une ampoule en quartz scellée sous vide et l'étape de frittage par SPS. Il en résulte une élaboration du composé de l'invention en trois étapes.

La première étape de synthèse est identique à celle décrite pour le premier mode de réalisation. Après que les poudres refroidies soient broyées manuellement avec un mortier et passées à travers des tamis avec une ouverture de maille de 150 $\mu$m pour obtenir des poudres présentant des tailles de particules homogènes, la poudre résultante subit une nano-structuration en étant moulue dans un broyeur à billes, ce qui permet de diminuer la taille des particules.

Dans cet exemple, le broyage est réalisé à une vitesse de 1200 rpm pendant 10h avec des billes de diamètre de 3mm. Le rapport massique entre la poudre et les billes est de 1/10.

En sortie de broyage par le broyeur à billes, on place les poudres dans un moule cylindrique entre deux poinçons et on prépare des pastilles par la méthode de frittage par SPS conformément à celle décrite pour le premier mode de réalisation.

Les figures 10 et 11 illustrent l'évolution de la conductivité thermique et du facteur de mérite en fonction de la température de deux composés à base de CoSbS0,75S0,25 dopé à 5,5 pour cent de tellure sur le site de l'antimoine, l'antimoine étant présent en sous stœchiométrie correspondant à hauteur de 94,5 pour cent. Les points référencés 10 correspondent au composé tel que précédemment défini obtenu selon le premier exemple de réalisation en deux étapes, et les points référencés 11 correspondent au même composé obtenu selon le second exemple de réalisation en trois étapes.

On constate que les meilleurs résultats en termes de conductivité thermique et de figure de mérite sont obtenus pour les poudres réalisées selon le second mode de réalisation en trois étapes. La conductivité thermique est notablement réduite lorsque le composé de l'invention est réalisé selon le second mode de réalisation. Et la figure de mérite croit d'environ 15 pour cent pour atteindre une valeur de 0,71 à 460°C lorsque le composé est réalisé selon le second mode de réalisation, au lieu de 0,61 lorsque le composé est réalisé selon le premier mode de réalisation. On notera une sensible différence de résultats entre les points référencés 10 des figures 10 et 11 et les points référencés 9 des figures 8 et 9, cette différence résultant uniquement de deux préparations indépendantes des composés.

Les applications de ce composé thermoélectrique sont nombreuses. On citera notamment son emploi dans la construction, les centrales, les usines, les véhicules et dans tout type d'appareil et d'appareillage.

Pour des performances à basse température, ce composé thermoélectrique trouve application dans la production d'énergie à partir des pertes de chaleur des ordinateurs par exemple.

**Revendications**

1. Composé thermoélectrique à base d'un alliage de sulfure de cobalt et d'antimoine avec du sélénium de formule CoSbS1-xSex, x étant selon 0 < x < 1, lequel alliage est dopé par du tellure sur le site de l'antimoine.

2. Composé thermoélectrique selon la revendication 1, **caractérisé en ce que** x est compris entre 0,1 et 0,6.

3. Composé thermoélectrique selon l'une quelconque des revendications 1 et 2, **caractérisé en ce que** x est égal à 0,25.

4. Composé thermoélectrique selon l'une quelconque des revendications 1 à 3, **caractérisé en ce que** le pourcentage atomique de tellure par rapport à l'antimoine présent dans le sulfure de cobalt et d'antimoine en stœchiométrie est compris entre 2 et 7.

5. Composé thermoélectrique selon l'une quelconque des revendications 1 à 4, **caractérisé en ce que** le pourcentage atomique de tellure par rapport à l'antimoine présent dans le sulfure de cobalt et d'antimoine en stœchiométrie est compris entre 5 et 6.

6. Composé thermoélectrique selon l'une quelconque des revendications 1 à 5, **caractérisé en ce que** l'alliage de sulfure de cobalt et d'antimoine avec du sélénium est en sous stœchiométrie d'antimoine.

7. Composé thermoélectrique selon la revendication 6, **caractérisé en ce que** le pourcentage atomique d'antimoine retiré est égal au pourcentage atomique de tellure ajouté, les pourcentages atomiques étant considérés par rapport à l'antimoine présent dans le sulfure de cobalt et d'antimoine en stœchiométrie.

8. Composé thermoélectrique selon l'une quelconque des revendications précédentes, **caractérisé en ce qu'**il est dopé sur le site du cobalt par du nickel, du palladium ou du platine.

9. Procédé de fabrication d'un composé thermoélectrique selon l'une des revendications 1 à 8, **caractérisé en ce qu'**il comprend au moins :

    - une première étape de synthèse du dit composé par mélange des poudres préalablement pesées de cobalt, d'antimoine, de soufre, de sélénium, de tellure et d'éventuels autre(s) dopant(s), et chauffage dudit mélange, et
    - une seconde étape consistant à réaliser un compactage par frittage des poudres.

10. Procédé selon la revendication 9, **caractérisé en ce qu'**il comporte une étape supplémentaire de nano-structuration des poudres entre la première et la seconde étape.

11. Procédé selon la revendication 10, **caractérisé en ce que** la nano-structuration est réalisée par broyage des poudres dans un broyeur à billes.

12. Procédé selon l'une quelconque des revendications 9 à 11, **caractérisé en ce que** l'étape de frittage est réalisé par la méthode de frittage intitulée SPS (Spark Plasma Sintering).

13. Procédé selon l'une quelconque des revendications 9 à 12, **caractérisé en ce que** le mélange chauffé lors de la première étape est refroidit, puis les poudres sont broyées manuellement avec un mortier.

14. Procédé selon la revendication 13, **caractérisé en ce que** les poudres refroidies et broyées sont passées à travers des tamis pour obtenir des poudres présentant des tailles de particules homogènes.

**Patentansprüche**

1. Thermoelektrische Verbindung aus einer Kobaltantimonsulfidlegierung mit Selen der Formel CoSbS1 - xSex, wobei x 0 < x < 1 ist, wobei die Legierung an der Antimonstelle Tellur-dotiert ist.

**2.** Thermoelektrische Verbindung nach Anspruch 1, **dadurch gekennzeichnet, dass** x zwischen 0,1 und 0,6 liegt.

**3.** Thermoelektrische Verbindung nach einem der Ansprüche 1 und 2, **dadurch gekennzeichnet, dass** x gleich 0,25 ist.

**4.** Thermoelektrische Verbindung nach einem der Ansprüche 1 bis 3, **dadurch gekennzeichnet, dass** der Atomprozentsatz von Tellur in Bezug auf das im Kobaltantimonsulfid vorhandene Antimon stöchiometrisch zwischen 2 und 7 liegt.

**5.** Thermoelektrische Verbindung nach einem der Ansprüche 1 bis 4, **dadurch gekennzeichnet, dass** der Atomprozentsatz von Tellur in Bezug auf das im Kobaltantimonsulfid vorhandene Antimon stöchiometrisch zwischen 5 und 6 liegt.

**6.** Thermoelektrische Verbindung nach einem der Ansprüche 1 bis 5, **dadurch gekennzeichnet, dass** die Kobaltantimonsulfidlegierung mit Selen Antimonunterstöchiometrisch ist.

**7.** Thermoelektrische Verbindung nach Anspruch 6, **dadurch gekennzeichnet, dass** der Atomprozentsatz entfernten Antimons gleich dem Atomprozentsatz hinzugefügten Tellurs ist, wobei die Atomprozentsätze in Bezug auf das im Kobaltantimonsulfid vorhandene Antimon stöchiometrisch betrachtet ist.

**8.** Thermoelektrische Verbindung nach einem der vorangegangenen Ansprüche, **dadurch gekennzeichnet, dass** sie an der Kobaltstelle mit Nickel, Palladium oder Platin dotiert ist.

**9.** Verfahren zur Herstellung einer thermoelektrischen Verbindung nach einem der Ansprüche 1 bis 8, **dadurch gekennzeichnet, dass** es mindestens umfasst:

- einen ersten Syntheseschritt der Verbindung durch Mischen der zuvor gewogenen Pulver von Kobalt-, Antimon-, Schwefel-, Selen-, Tellur- und eines eventuell anderen/r Dotierungsmittel/s und Erhitzen des Gemischs, und
- einen zweiten Schritt, der darin besteht, eine Kompaktierung durch Sintern der Pulver durchzuführen.

**10.** Verfahren nach Anspruch 9, **dadurch gekennzeichnet, dass** es einen zusätzlichen Schritt der Nano-Strukturierung der Pulver zwischen dem ersten und dem zweiten Schritt aufweist.

**11.** Verfahren nach Anspruch 10, **dadurch gekennzeichnet, dass** die Nano-Strukturierung durch Zerkleinern der Pulver in einer Kugelmühle durchgeführt wird.

**12.** Verfahren nach einem der Ansprüche 9 bis 11, **dadurch gekennzeichnet, dass** der Schritt des Sinterns durch die als SPS (Spark Plasma Sintering) bezeichnete Sintermethode durchgeführt wird.

**13.** Verfahren nach einem der Ansprüche 9 bis 12, **dadurch gekennzeichnet, dass** das beim ersten Schritt erhitzte Gemisch abgekühlt wird und die Pulver dann mit einem Mörser manuell zerkleinert werden.

**14.** Verfahren nach Anspruch 13, **dadurch gekennzeichnet, dass** die abgekühlten und zerkleinerten Pulver durch Siebe geleitet werden, um Pulver zu erhalten, die homogene Partikelgrößen aufweisen.

**Claims**

**1.** Thermoelectric compound based on a cobalt antimony sulfide alloy with selenium of formula $CoSbS_{1-x}Se_x$, x being according to $0 < x < 1$, said alloy is doped with tellurium on the antimony site.

**2.** The thermoelectric compound according to claim 1, **characterized in that** x is between 0.1 and 0.6.

**3.** The thermoelectric compound according to any of claims 1 and 2, **characterized in that** x is 0.25.

**4.** The thermoelectric compound according to any of claims 1 to 3, **characterized in that** the atomic percentage of tellurium relative to the antimony contained in the cobalt antimony sulfide, in stoichiometry, is between 2 and 7.

5. The thermoelectric compound method according to any of claims 1 to 4, **characterized in that** the atomic percentage of tellurium relative to the antimony contained in the cobalt antimony sulfide, in stoichiometry, is between 5 and 6.

6. The thermoelectric compound according to any of claims 1 to 5, **characterized in that** the alloy of cobalt antimony sulfide with selenium has sub-stoichiometry of antimony.

7. The thermoelectric compound according to claim 6, **characterized in that** the atomic percentage of withdrawn antimony is equal to the atomic percentage of added tellurium, the atomic percentages being considered in relation to the antimony contained in the cobalt antimony sulfide in stoichiometry.

8. The thermoelectric compound according to any of the preceding claims, **characterized in that** it is doped on the cobalt site with nickel, palladium or platinum.

9. Method for preparing a thermoelectric compound according to any of claims 1 to 8, **characterized in that** it comprises at least:

   - a first step to synthesise said compound by mixing previously weighed powders of cobalt, antimony, sulfur, selenium, tellurium and optional other dopant(s), and heating said mixture; and
   - a second step to compact the powders via sintering.

10. The method according to claim 9, **characterized in that** it comprises an additional step for nano-structuring of the powders between the first and second steps.

11. The method according to claim 10, **characterized in that** nano-structuring is performed by grinding the powders in a ball mill.

12. The method according to any of claims 9 to 11, **characterized in that** the sintering step is performed with the Spark Plasma Sintering method (SPS).

13. The method according to any of claims 9 to 12, **characterized in that** the mixture heated at the first step is cooled, and the powders are manually ground in a mortar.

14. The method according to claim 13, **characterized in that** the cooled, ground powders are screened to obtain powders having homogeneous particle size.

*Fig.1*

*Fig.2*

*Fig.3*

*Fig.4*

*Fig.5*

*Fig.6*

_Fig.7_

_Fig.8_

*Fig.9*

*Fig.10*

Fig.11

RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **YE X et al.** Effect of Te-Se-S Triple Doping on the Thermoelectric Properties of CoSb3 Skutterudites. *JOURNAL OF ELECTRONIC MATERIALS,* 03 Décembre 2014, vol. 44 (6

- High thermoelectric performance of tellurium doped paracostibite. **CHMIELOWSKI et al.** Journal of Materials Chemistry C. Royal Society of Chemistry, 10 Février 2016